Europäisches Patentamt

European Patent Office

Office européen des brevets

(11) Veröffentlichungsnummer: **0 346 750 B1**

(12) **EUROPÄISCHE PATENTSCHRIFT**

(45) Veröffentlichungstag der Patentschrift: **09.06.93**

(21) Anmeldenummer: **89110290.7**

(22) Anmeldetag: **07.06.89**

(51) Int. Cl.⁵: **H04N 7/137**

(54) **Anordnung zur DPCM-Codierung mit hoher Datenrate.**

(30) Priorität: **14.06.88 DE 3820234**

(43) Veröffentlichungstag der Anmeldung:
**20.12.89 Patentblatt 89/51**

(45) Bekanntmachung des Hinweises auf die
Patenterteilung:
**09.06.93 Patentblatt 93/23**

(84) Benannte Vertragsstaaten:
**DE FR GB IT**

(56) Entgegenhaltungen:
**GB-A- 2 208 339**

**PROCEEDINGS OF THE IEEE INTERNATIONAL
CONFERENCE ON COMMUNICATIONS Band
2, Mai 1984, Seiten 711-717, Amsterdam, NL;
B. GIROD : "Reconstruction noise shaping in
the context of predictive TV signal coding"**

**PATENT ABSTRACTS OF JAPAN, Band 9, Nr.
263 (E-351)(1986) 19. Oktober 1985; & JP-A-
60 109 985 (FUJITSU) 15.06.1985**

**FUNKSCHAU 1973, Band 45, Heft 16, 3. August 1973, Seiten 591-593, DE; H. SCHOEN-
FELDER : "Nachrichtenreduktion für Bildsignale"**

(73) Patentinhaber: **SIEMENS AKTIENGESELL-
SCHAFT
Wittelsbacherplatz 2
W-8000 München 2(DE)**

(72) Erfinder: **Mattausch, Hans-Jürgen, Dr. rer. nat.
Am Brunnen 25
W-8011 Kirchheim(DE)**
Erfinder: **Matthiesen, Fred, Dipl.-Ing.
Kolumbusstrasse 19
W-8000 München 90(DE)**
Erfinder: **Schöbinger, Matthias, Dr. phil. nat.
Schleissheimer Strasse 71
W-8000 München 40(DE)**

## Beschreibung

Die Erfindung bezieht sich auf eine Anordnung zur DPCM-Codierung mit hohen Datenraten nach dem Oberbegriff des Patentanspruchs 1.

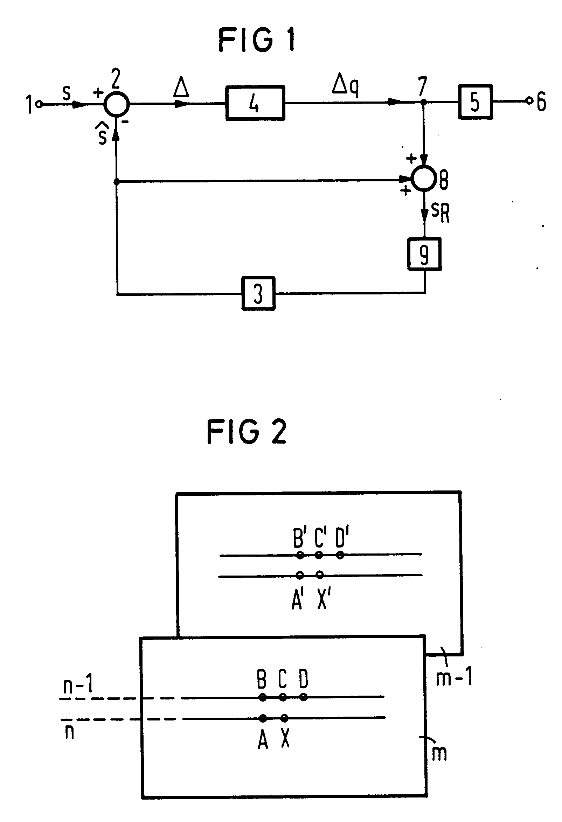

Eine Anordnung zu DPCM-Codierung, die zum Beispiel aus den Proc. IEEE Bd. 73, Nr. 4, April 1985, Seiten 592 bis 598, vergleiche insbesondere Figuren 1, 2 und 4, bekannt ist, sei anhand eines in Figur 1 dargestellten Prinzipschaltbildes erläutert. Dabei liegt an einem Eingang 1 der Anordnung eine Folge von digitalisierten Bildpunktsignalen s an, die über im einzelnen nicht dargestellte Abtast- und Haltestufen zugeführt werden. Zur Reduktion des Datenflusses bemüht man sich, redundante und irrelevante Anteile des Bildsignals herauszunehmen, um beispielsweise die Bitübertragungsrate senken zu können, ohne die Bildqualität hierdurch zu verschlechtern. Im einzelnen geschieht dies dadurch, daß nicht die aufeinanderfolgenden Bildpunktsignale über den zu einer Empfangsstelle führenden Übertragungskanal übertragen werden, sondern nur die Differenzsignale, die durch eine Differenzbildung zwischen jeweils einem aktuellen Bildpunktsignal s und einem aufgrund der vorausgegangenen Bildpunktsignale in einem Prädiktor ermittelten Prädiktionswert $\hat{s}$ gebildet werden. Ein solches Verfahren wird auch als Differenz-Pulscodemodulation (DPCM) bezeichnet.

Die für eine DPCM-Codierung erforderliche Differenzbildung geschieht nach Fig. 1 in einem Subtrahierer 2, dessen erster Eingang mit dem Eingang 1 und dessen zweiter Eingang mit einem Prädiktor 3 beschaltet ist. Jedes Differenzsignal $\Delta$, das auch als Prädiktionsfehler bezeichnet wird, wird in einem Quantisierer 4 quantisiert, wobei das sich ergebende, mit dem Quantisierungsfehler q behaftete Differenzsignal $\Delta_q = \Delta + q$ in einem Codierer 5 codiert und über einen Ausgang 6 dem Übertragungskanal zugeführt wird. Zur Bildung des Prädiktionswertes $\hat{s}$ ist ein rekursiver Signalpfad vorgesehen, der von einem Schaltungspunkt 7 ausgangsseitig vom Quantisierer 4 ausgeht, einen ersten Addierer 8, eine Begrenzereinrichtung 9 und den Prädiktor 3 enthält und an den zweiten Eingang des Subtrahierers 2 geführt ist. Der Ausgang des Prädiktors 3 ist weiterhin mit einem zweiten Eingang des ersten Addierers 8 verbunden, der durch Addition des quantisierten Differenzsignals $\Delta_q$ und des Prädiktionswertes $\hat{s}$ ein sog. rekonstruiertes Bildpunktsignal $s_R$ bildet. Für jedes aktuelle Bildpunktsignal s liefert der Prädiktor 3 aus wenigstens einem der vorhergegangenen Bildpunktsignale den Prädiktionswert $\hat{s}$

Bezeichnet man gemäß Fig. 2 den in einem Fernsehbild m in der Zeile n liegenden, aktuellen Bildpunkt mit X, den unmittelbar vorher abgetasteten Bildpunkt mit A, den X entsprechenden Bildpunkt der vorhergehenden Zeile n - l mit C und die dem letzteren benachbarten, unmittelbar vor bzw. nach diesem abgetasteten Bildpunkte mit B und D und bezeichnet man weiterhin die entsprechenden Bildpunkte des vorhergegangenen Bildes m - l mit X' und A' bis D', so ergibt sich folgendes: Man kann zur Bildung des Prädiktionswertes $\hat{s}$ für das Bildpunktsignal von X die Bildpunktsignale von wenigstens einem der Punkte A bis D heranziehen, wobei man von einer zweidimensionalen (2D-) Prädiktion spricht. Verwendet man hierzu zusätzlich oder ausschließlich die Bildpunktsignale von wenigstens einem der Bildpunkte X' und A' bis D', so liegt eine dreidimensionale (3D-) Prädiktion vor. Im ersteren Falle kann der Prädiktionswert $\hat{s}$ beispielsweise nach der 2D-Schätzgleichung

$$\hat{s} = \alpha \cdot s_A + \beta \cdot s_B + \gamma \cdot s_C + \delta \cdot s_D \qquad (1)$$

ermittelt werden, im letzteren Fall zum Beispiel nach der 3D-Schätzgleichung

$$\hat{s} = \alpha \cdot s_A + \beta \cdot s_{X'} \qquad (2)$$

wobei mit $s_A$ das rekonstruierte Bildpunktsignal des Bildpunktes A bezeichnet ist, mit $s_B$ das des Bildpunktes B usw. und wobei die Koeffizienten $\alpha$, $\beta$, $\gamma$ und $\delta$ Bewertungsfaktoren darstellen, die den einzelnen Bildpunktsignalen zugeordnet sind.

Die Veröffentlichung "Architektur und Schaltkreistechnik in CMOS-ICs für die DPCM-Codierung von Videosignalen" von Peter Pirsch aus der Mitteilung des Forschungszentrums der SEL AG in Stuttgart, S. 213-222, gibt einen Überblick über das Prinzip der DPCM-Technik, ein DPCM-System mit zweidimensionaler Prädiktion und DPCM-Architekturlösungen werden vorgestellt. Bild 5 der angegebenen Veröffentlichung gibt ein modifiziertes DPCM-System mit vierstufiger Prädiktionsfehlerbestimmung und einen Prädiktor an. Der zeitkritische Pfad in dieser Anordnung besteht lediglich aus einem Subtrahierer, einem Quantisierer und einem Register. Neben diesem Pfad existieren nur noch weitere Pfade, bei denen zwischen zwei aufeinanderfolgenden Registern zwei Additionen bzw. eine Addition und eine Subtraktion erforderlich sind. Aus den auf Seite 218 im dritten Absatz angegebenen Gründen ist es erforderlich, eine Begrenzerfunktion bei einer Anordnung nach Bild 5 nicht innerhalb einer Schleife, sondern eingangsseitig vorzunehmen. Somit wird zur Verhinderung von Über- und Unterlaufen der Zahlenbereich des Eingangssignals eingeschränkt, was in vielen Fällen jedoch unerwünscht ist. Die Begrenzerfunktion sollte erst bei in der DPCM-Anordnung entstehenden Über- oder Unterläufen aktiviert werden.

Der Erfindung liegt die Aufgabe zugrunde, eine weitere Anordnung zur DPCM-Codierung anzugeben, bei der eine schnelle Signalverarbeitung bei einem möglichst einfachen Schaltungsaufbau gewährleistet ist. Das wird erfindungsgemäß durch eine Ausbildung der Anordnung nach dem kennzeichnenden Teil des Patentanspruchs 1 erreicht.

Der mit der Erfindung erzielbare Vorteil liegt insbesondere darin, daß eine gewünschte Begrenzerfunktion in einer Weiterbildung der Erfindung nicht eingangsseitig angeordnet werden muß und die Anordnung in der Weiterbildung den für ein DPCM-System kürzest möglichen kritischen Pfad (ein Quantisierzugriff, eine Addition und ein Register) aufweist. Falls eine Begrenzung für den rekonstruierten Wert erforderlich ist (wie z.B. in der COST-Spezifikation für das ISDN-Breitbandsystem), so wird der kritische Pfad lediglich um eine Überlauferkennung und einen Multiplexer verlängert. Weiterhin vorteilhaft ist es, daß im Gegensatz zu Systemen, die einen ähnlich kurzen kritischen Pfad durch rekursives Einsetzen in die Prädiktionsgleichung ableiten (siehe Bild 5 der genannten zweiten Veröffentlichung auf Seite 219) hierbei der Wert aus der 2D- bzw. 3D-Prädiktion nur einmal subtrahiert wird. Die Anzahl der Addierer ist geringer. Bei den meisten möglichen Quantisierungs-Kennlinien ist der Wertebereich des Quantisierungsfehlers kleiner als der Wertebereich der Repräsentativwerte. Der erforderliche Speicher muß also vorteilhafterweise weniger Stellen ausgeben und ist daher kleiner. Ebenso ist bei extern realisiertem Speicher der I/O-Aufwand geringer gegenüber Anordnungen der herkömmlichen Art.

Die Patentansprüche 2 bis 11 sind auf bevorzugte Ausgestaltungen und Weiterbildungen der Erfindung gerichtet.

Die Erfindung wird nachfolgend anhand von in der Zeichnung dargestellten, bevorzugten Ausführungsbeispielen näher erläutert. Dabei zeigt:

Fig. 1  das Prinzipschaltbild einer bekannten Anordnung zur DPCM-Codierung,

Fig. 2  eine Darstellung von einzelnen Bildpunkten zweier aufeinanderfolgender Fernsehbilder zur Erläuterung von Fig. 1,

Fig. 3  ein erstes Ausführungsbeispiel der Erfindung,

Fig. 4  eine erste Weiterbildung der Anordnung nach Fig. 3,

Fig. 5  eine zweite Weiterbildung der Anordnung nach Fig. 3,

Fig. 6  eine Weiterbildung der Anordnung nach Fig. 5 mit einem kürzest möglichen kritischen Pfad,

Fig. 7  eine Weiterbildung der Anordnung nach Fig. 6 mit zusätzlichen Registern, und

Fig. 8  eine DPCM-Anordnung nach der Erfindung mit Begrenzerfunktion.

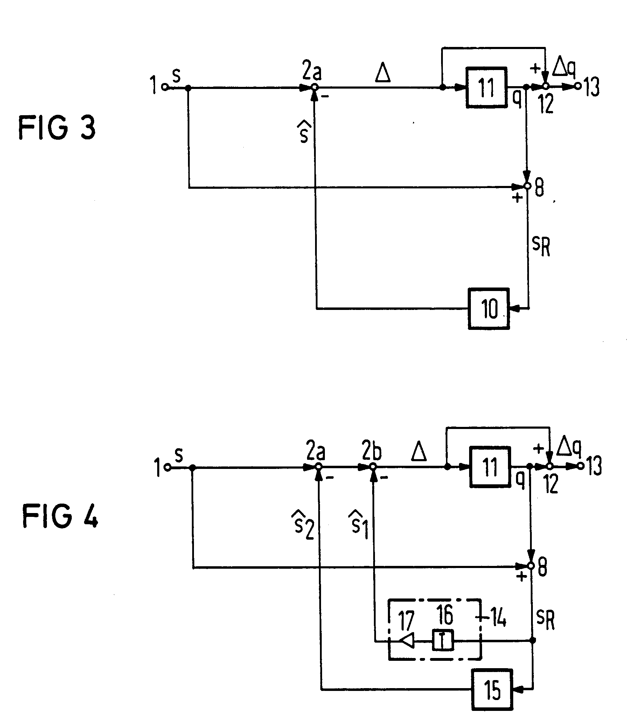

Die für eine DPCM-Codierung erforderliche Differenzbildung geschieht im ersten Ausführungsbeispiel nach Fig. 3 wie auch im Prinzipschaltbild der bekannten Anordnung nach Fig. 1 in einem Subtrahierer 2a, dessen erster Eingang mit dem Eingang 1 der DPCM-Schaltung und dessen zweiter Eingang mit einem Prädiktor 10 verschaltet ist. Alle Differenzsignale bzw. Prädiktionsfehler werden anstatt einem Quantisierer einer Einrichtung zur Ausgabe eines zu einem Differenzsignal zugehörigen Quantisierungsfehlers 11 zugeführt. Weiterhin weist die erfindungsgemäße Anordnung nach Fig. 3 einen zusätzlichen Addierer 12 auf, dessen erster Eingang mit dem Ausgang der zuletzt genannten Anordnung und über einen zweiten Eingang mit dem Ausgang des Subtrahierers 2a verschaltet ist. Innerhalb dieses Addierers 12 entsteht der quantisierte Prädiktionsfehler $\Delta q$ dadurch, daß zu dem Prädiktionsfehler $\Delta$ am Ausgang des Subtrahierers 2a der zugehörige Quantisierungsfehler q addiert wird. Der Ausgang 13 des weiteren Addierers 12, welcher den quantisierten Prädiktionsfehler $\Delta q$ liefert, ist über einen nicht dargestellten Codierer mit einem Übertragungskanal verbunden. Zur Bildung des Prädiktionswertes $\hat{s}$ ist ein rekursiver Signalpfad vorgesehen, der von dem Ausgang der Anordnung zur Ausgabe eines zu einem Differenzsignal zugehörigen Quantisierungsfehlers 11 ausgeht, einen ersten Addierer 8 und einen Prädiktor 10 enthält und an den zweiten Eingang des Subtrahierers 2a geführt ist. Der Ausgang des ersten Addierers liefert genau wie die DPCM-Struktur nach Bild 1 ein sog. rekonstruiertes Bildpunktsignal $s_R$. Nach der bekannten DPCM-Struktur aus Fig. 1 entsteht dieses Bildpunktsignal $s_R$ aus einer Addition des Prädiktionswertes $\hat{s}$ und des quantisierten Prädiktionsfehlers $\Delta q$. Anstelle des quantisierten Prädiktionsfehlers $\Delta q$ wird nach der erfindungsgemäßen DPCM-Struktur aus Fig. 3 dem zweiten Addierer 8 der zu einem bestimmten Differenzsignal zugehörige Quantisierungsfehler q über den ersten Eingang zugeführt und auf den zweiten Eingang des ersten Addierers 8 wird das aktuelle Bildpunktsignal s, das am Eingang 1 liegt, aufgeschaltet. Somit ergibt sich das rekonstruierte Bildpunktsignal $s_R$ aus einer Addition des Bildpunktsignals s und des zu dem Differenzsignal zugehörigen Quantisierungsfehlers q. Die Prädiktion und die Berechnung des Prädiktionsfehlers $\Delta$ erfährt in der erfindungsgemäßen Schaltung nach Fig. 3 keinerlei Änderung. Der Quantisierungsfehler q wird dem Prädiktionsfehler $\Delta$ durch einen Speicher, ein PLA oder eine Anordnung von logischen Gattern zugeordnet.

Mit Hilfe der Einrichtung zur Ausgabe eines zu einem Differenzsignal zugehörigen Quantisierungsfehlers 11 ist es nun möglich, einen einfacheren Schaltungsaufbau gegenüber dem herkömmlichen Stand der DPCM-Technik durchzuführen. Der hierfür benötigte Speicher hat im allgemeinen eine geringere Stellenzahl als der Quantisierer in der DPCM-Struktur nach herkömmlicher Anordnung, da dem großen Wertebereich der Repräsentativwerte über die Quantisierungskennlinie ein kleinerer Wertebereich von zugehörigen Quantisierungsfehlern gegenübersteht.

Fig. 4 zeigt eine erste Weiterbildung der Anordnung nach Fig. 3, bei der der Prädiktor in einen 1D- und 2D/3D-Prädiktor 14, 15 aufgeteilt wurde. Hierbei verarbeitet der eindimensionale Prädiktor 14 den unmittelbar vorangegangenen Wert, während der zwei-bzw. dreidimensionale Prädiktor 15 alle übrigen Werte verarbeitet. Zu diesen übrigen Werten zählen beispielsweise die Bildpunkte der vorhergehenden Zeile oder die Bildpunkte des vorhergegangenen Bildes. Die Anteile $\hat{s}_1$, $\hat{s}_2$ des eindimensionalen bzw. zweidimensionalen/ dreidimensionalen Prädiktors werden nacheinander vom aktuellen Bildpunktsignal subtrahiert, so daß ein zweiter Subtrahierer 2b hierfür erforderlich wird. Dieser zweite Subtrahierer 2b ist zwischen dem ersten Subtrahierer 2a und der Einrichtung zur Ausgabe eines zu einem Differenzsignal zugehörigen Quantisierungsfehlers 11 geschaltet, so daß der Ausgang des ersten Subtrahierers 2a mit dem ersten Eingang des zweiten Substrahierers 2b und der Ausgang des zweiten Subtrahierers 2b mit dem Eingang der zuletzt genannten Einrichtung 11 verbunden ist. Der zweite Eingang des zweiten Subtrahierers 2b ist über den eindimensionalen Prädiktor 14 mit dem Ausgang des ersten Addierers 8 verbunden, so daß auf dem Eingang des eindimensionalen Prädiktors 14 das rekonstruierte Bildpunktsignal $s_R$ anliegt. Der eindimensionale Prädiktor 14 wird nach Fig. 4 aus einer Reihenschaltung eines Registers 16 und eines Bewerters 17 gebildet, wobei der Bewerter 17 das rekonstruierte Bildpunktsignal $s_R$ mit dem Wert $\alpha$ gewichtet. Der eindimensionale Prädiktor 14 verzögert dabei das rekonstruierte Bildpunktsignal $s_R$ um einen Takt und multipliziert es mit einem Gewichtungsfaktor $\alpha$. Die grundsätzliche Verschaltung der Anordnung nach Fig. 4 entspricht der DPCM-Struktur nach Fig. 3, so daß der zum Stand der Technik gehörende Quantisierer 4 durch eine Einrichtung zur Ausgabe eines zu einem Differenzsignal zugehörigen Quantisierungsfehlers 11 mit einem nachgeschalteten Addierer 12 ersetzt ist.

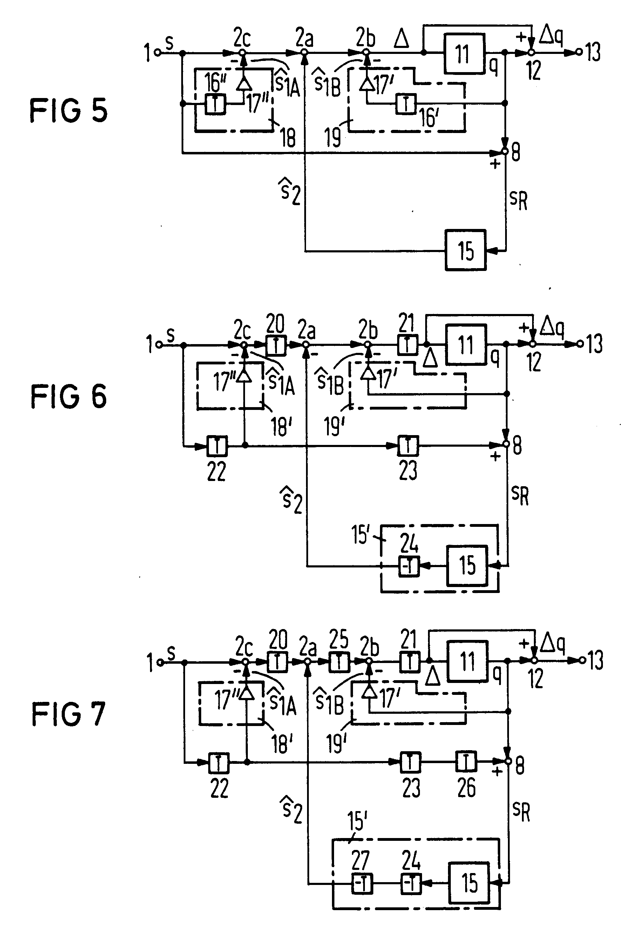

Fig. 5 zeigt eine zweite Weiterbildung der DPCM-Struktur nach Fig. 3. Da das rekonstruierte Bildpunktsignal $s_R$ aus der Addition des aktuellen Bildpunktsignals s und des zu dem Differenzsignal zugehörigen Quantisierungsfehlers q berechnet wird, kann der eindimensionale Prädiktor wiederum in einen ersten Teil 18, der das aktuelle Bildpunktsignal s verzögert und mit dem Gewichtungsfaktor $\alpha$ multipliziert und in einen zweiten Teil 19, der den zum Differenzsignal zugehörigen Quantisierungsfehler q verzögert und ebenfalls mit dem Bewertungsfaktor $\alpha$ multipliziert, aufgespalten werden. Diese beiden Anteile $\hat{s}_{1A}$, $\hat{s}_{1B}$ werden ebenfalls nacheinander vom aktuellen Bildpunktsignal s subtrahiert, so daß gegenüber der DPCM-Struktur nach Fig. 3 zwei zusätzliche Subtrahierer 2b, 2c erforderlich sind. Ein Eingang des zweiten zusätzlichen Subtrahierers 2c ist hierbei mit dem aktuellen Bildpunktsignal s verschaltet, während ein weiterer Eingang über den ersten Teil 18 des eindimensionalen Prädiktors an den Eingang 1 der DPCM--Struktur angeschlossen ist. Der Ausgang des zuletzt genannten Subtrahierers 2c ist auf den ersten Eingang des ersten Subtrahierers 2a und der Ausgang des ersten Subtrahierers 2a ist mit dem ersten Eingang des dritten zusätzlichen Subtrahierers 2b und der Ausgang dieses Subtrahierers 2b mit der Einrichtung zur Ausgabe eines zu einem Differenzsignal zugehörigen Quantisierungsfehlers 11 verbunden. Zwischen dem Ausgang der Einrichtung zur Ausgabe eines zu einem Differenzsignal zugehörigen Quantisierungsfehlers 11 und dem zweiten Eingang des dritten Subtrahierers 2b ist der zweite Teil 19 des eindimensionalen Prädiktors angeordnet. Sowohl der erste als auch der zweite Teil des eindimensionalen Prädiktors bestehen aus einer Reihenschaltung eines Registers (16″, 16′ und eines nachgeschalteten Bewerters 17″, 17′, der das aktuelle Bildpunktsignal s bzw. den zu dem Differenzsignal zugehörigen Quantisierungsfehler q mit dem Gewichtungsfaktor $\alpha$ multipliziert). Die übrige Verschaltung, insbesondere des 2D-bzw. des 3D-Prädiktors, sowie der Einrichtung zur Ausgabe eines zu einem Differenzsignal zugehörigen Quantisierungsfehlers 11 mit dem nachgeschalteten Addierer 12 entsprechen der DPCM-Struktur nach Fig. 4.

Eine Weiterbildung der erfindungsgemäßen DPCM-Struktur Fig. 5 mit einem kürzest möglichen kristischen Pfad zeigt Fig. 6. Genau wie in der DPCM-Anordnung nach Fig. 5 ist der Prädiktor aufgeteilt in einen 2D- bzw. 3D-Prädiktor 15′ und in einen 1D-Prädiktor, der aus einem ersten und zweiten Teil 18′, 19′ besteht. Ein weiterer Vergleich mit der zuletzt genannten DPCM-Struktur zeigt, daß einige Register an anderer Stelle angeordnet oder ergänzt wurden, während hingegen ein Register 24 aus dem Zeilen- bzw. Bildspeicher des 2D-bzw. 3D-Prädiktors entfernt wurde, was durch die Beschreibung mit "-T" angedeutet wird. Durch diese Maßnahme ist es möglich, den für eine DPCM-Struktur kürzest möglichen kritischen Pfad (ein Quantisiererzugriff, eine Addition und ein Register; sofern der Gewichtungsfaktor $\alpha$ aus einer Zweierpotenz besteht und damit durch eine keine Rechenzeit benötigende Busverschiebung realisiert werden kann) aufzubauen, die eine hohe Verarbeitungsgeschwindigkeit der DPCM-Struktur gewährleistet. Aufgrund der Umstellung der Register in der DPCM-Struktur ist es auch notwendig, je ein Register im Ein- und Ausgangsbereich zu entfernen, um die gleiche Funktion wie in Fig. 5 zu erhalten. Wird dies, wie hier dargestellt, unterlassen, wird zwar die Latenzzeit der Schaltung, d.h. die Zeit von der Eingabe eines Eingangswertes bis zur Ausgabe des zugehörigen Ausgangswertes erhöht, die Funktion der DPCM-Struktur ändert sich jedoch nicht. Der strukturelle Aufbau, insbesondere der Anordnung des ersten, zweiten und dritten Subtrahierers 2a, 2c, 2b, des ersten Addierers 8 sowie der Einrichtung zur Ausgabe eines zu einem Differenzsignal zugehörigen Quantisierungsfehlers 11 mit nachgeschaltetem Addierer 12 und die Anordnung des 2D- bzw. 3D-Prädiktors 15' gleicht der DPCM-Struktur nach Fig. 5, mit folgenden Ausnahmen. Der erste und zweite Teil 18', 19' des eindimensionalen Prädiktors besteht anstatt aus einer Reihenschaltung eines Registers und eines Bewerters, lediglich in beiden Fällen aus einem Bewerter 17'', 17'. Im rekursiven Signalpfad liegt der 2D- bzw. 3D-Prädiktor 15', dessen Zeilen-oder Bildspeicher um ein Register 24 gekürzt wurde. Dies ist in der Anordnung nach Fig. 6 dadurch angedeutet, daß auf einem in Fig. 4 und 5 verwendeten 2D- bzw. 3D-Prädiktor l5 ein "-T"-Register folgt. Weitere Register 20, 21 gegenüber der DPCM-Struktur nach Fig. 5 sind zwischen dem ersten und zweiten Subtrahierer 2a, 2c sowie zwischen dem dritten Subtrahierer 2b und dem Eingang der Einrichtung zur Ausgabe eines zu einem Differenzsignals zugehörigen Quantisierungsfehlers 11 wiedergegeben, während der Signalpfad mit dem aktuellen Bildpunktsignal zum zweiten Eingang des ersten Addierers 8 mit einer Reihenschaltung zweier Register 22, 23 versehen ist. Der erste Teil 18' des eindimensionalen Prädiktors ist hierbei mit seinem ersten Anschluß zwischen den beiden zuletzt genannten Registern 22, 23 und mit seinem zweiten Anschluß mit dem zweiten Eingang des zweiten Subtrahierers 2c verschaltet.

Fig. 7 zeigt eine Weiterbildung der DPCM-Struktur nach Fig. 6 mit einem zusätzlichen Register, welches zwischen dem ersten und dritten Subtrahierer 2a, 2b angeordnet ist. Durch diese Maßnahme ist es möglich, bei im Vergleich zur Speicher-Zugriffszeit langsamen Addierern eine effektive Signalverarbeitung für die DPCM-Struktur zu ermöglichen. Im allgemeinen wird dies aber nicht nötig sein, da zwei kaskadierte Additionen schneller ablaufen als ein Speicherzugriff plus eine Addition. Sollte es dennoch erforderlich sein, ein Register 25 zwischen dem ersten und dritten Subtrahierer 2a, 2b anzuordnen, so ist auch ein weiteres Register 26 für den zweiten Eingang des ersten Addierers vorzusehen und der Bild- bzw. Zeilenspeicher des 2D-bzw. 3D-Prädiktors ist um insgesamt zwei Register 24, 27 zu kürzen. Die grundsätzliche Anordnung der DPCM-Struktur nach Fig. 7 entspricht hierbei der Anordnung Fig. 6, so daß auch hierbei der kürzest mögliche kritische Pfad, bestehend aus einem Quantisiererzugriff, einer Addition und einem Register vorhanden ist.

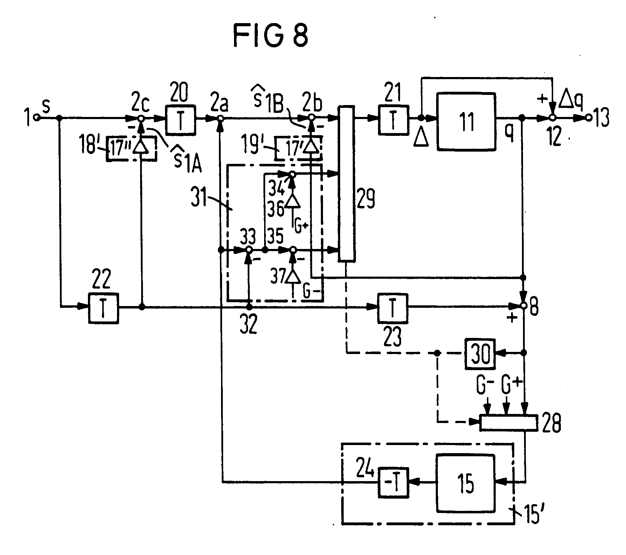

In vielen DPCM-Systemen muß der Wertebereich des rekonstruierten Bildpunktsignals begrenzt werden. Diese Begrenzungsfunktion kann auf die in Fig. 8 gezeigte Weise eingebaut werden. Die drei Zustände - unterhalb, innerhalb und oberhalb des Wertebereichs - werden von einer Überlauferkennung erkannt. Diese Überlauferkennung steuert einen Multiplexer, der zwischen den drei Werten - unterer Grenzwert, unbegrenzter Wert und oberer Grenzwert-auswählt. Bei der grundsätzlichen Verschaltung der DPCM-Anordnung nach Fig. 8 ist wiederum von einer Anordnung nach Fig. 6 auszugehen, wobei die gezeigte Anordnung zusätzlich über eine Überlauferkennung 30, zwei Multiplexer 28, 29 sowie drei Subtrahierer 33, 34, 35 verfügt. Die Überlauferkennung 30 ist hierbei mit dem Ausgang des ersten Addierers 8 verbunden und steuert mit ihrem Ausgang den ersten und zweiten Multiplexer 28, 29. Beide Multiplexer weisen jeweils zwei Eingänge und einen Ausgang auf, wobei der erste Multiplexer 28 an seinen ersten beiden Eingängen jeweils mit dem unteren bzw. oberen Grenzwert $G^-$, $G^+$ beschaltet ist, und der dritte Eingang gemeinsam mit dem Eingang der Überlauferkennung an den Ausgang des ersten Addierers 8 angeschlossen ist. Der Ausgang des ersten Multiplexers 28, der das erste rekonstruierte Bildpunktsignal $s_R$ führt, ist auf den Eingang des 2D- bzw. 3D-Prädiktors 15' gelegt. Der zweite Multiplexer 29 ist jeweils mit seinen ersten beiden Eingängen an den Ausgang eines vierten und fünften Subtrahierers 34, 35 angeschlossen, beide Eingänge der zuletzt genannten Subtrahierer sind parallel geschaltet und mit dem Ausgang eines sechsten Subtrahierers 33 verbunden, dessen erster Anschluß mit dem Anschlußpunkt 32 zwischen dem dritten und vierten Register 22, 23 und dessen zweiter Anschluß über den 2D- bzw. 3D-Prädiktor 15' mit dem rekonstruierten Bildpunktsignal $s_R$ beaufschlagt ist. Der 2D-bzw. 3D-Prädiktor weist hierbei wiederum einen Zeilen- bzw. Bildspeicher auf, der um ein Register 24 gegenüber der entsprechenden Prädiktoranordnung aus Fig. 3 gekürzt ist. Auf dem zweiten Eingang des vierten Subtrahierers 34 wird über einen Bewerter 36 der maximale Grenzwert $G^+$ geschaltet, und mit Hilfe des Bewerters 36 mit dem Gewichtungsfaktor $\alpha$ multipliziert, während der zweite Eingang des fünften Subtrahierers 35 über einen weiteren Bewerter 37 mit dem unteren Grenzwert $G^-$ verbunden ist und dieser Bewerter ebenfalls den unteren Grenzwert mit

dem Gewichtungsfaktor $\alpha$ multipliziert. Der dritte Eingang des zweiten Multiplexers 29 ist mit dem Ausgang des dritten Subtrahierers 2b verbunden und der Ausgang desselben Multiplexers 29 ist auf den Eingang des zweiten Registers 21 geschaltet. In dem Pfad für die eindimensionale Prädiktion kommt hierbei anstelle einer Begrenzeranordnung eine Parallelisierung zur Anwendung, die bereits in der Patentanmeldung EP-A-2 888 783 beschrieben wurde. Dieser Pfad rechnet für den unbegrenzten Fall

$$\Delta = s - \hat{s}_{1A} - \hat{s}_{1B} - \hat{s}_2$$

d.h. der Prädiktionsfehler $\Delta$ errechnet sich aus dem aktuellen Bildpunktsignal s abzüglich des Prädiktionswertes $\hat{s}_2$ aus dem 2D/3D-Prädiktor sowie des Signals aus dem ersten und zweiten Teil des eindimensionalen Prädiktors $\hat{s}_{1A}$ und $\hat{s}_{1B}$. Bei Einsatz der oberen Begrenzung ergibt sich

$$\Delta = s - \hat{s}_2 - \alpha \cdot G^+$$

d.h. der Prädiktionsfehler $\Delta$ ergibt sich aus dem aktuellen Bildpunktsignal s abzüglich des Prädiktionswertes $\hat{s}_2$ aus dem 2D/3D-Prädiktor sowie abzüglich des mit $\alpha$ multiplierten oberen Grenzwertes $G^+$. Bei Einsatz der unteren Begrenzung ergibt sich der Prädiktionsfehler

$$\Delta = \hat{s} - \hat{s}_2 - \alpha \cdot G^-$$

der Prädikationsfehler $\Delta$ ergibt sich also aus dem aktuellen Bildpunktsignal s abzüglich des Prädiktionswertes $\hat{s}_2$ aus dem 2D- bzw. 3D-Prädiktor und abzüglich des mit $\alpha$ multiplizierten unteren Grenzwertes $G^-$. Die zuletzt gezeigte DPCM-Struktur weist ebenso wie die DPCM-Struktur nach Fig. 6 und 7 einen kürzest möglichen kritischen Pfad, bestehend aus einem Quantisiererzugriff, einer Addition und einem Register, auf. Somit ist auch in der zuletzt genannten Anordnung eine möglichst hohe Verarbeitungsgeschwindigkeit möglich.

**Patentansprüche**

1. Anordnung zur DPCM-Kodierung hoher Datenrate, bei der von digitalisierten Bildpunktsignalen am Eingang (1) jeweils Prädiktionswerte subtrahiert und die erhaltenen Differenzsignale nach einer Verarbeitung zur Signalübertragung herangezogen werden, mit einem rekursiven Signalpfad, der einen ersten Addierer (8) zur Bildung von rekonstruierten Bildpunktsignalen ($s_R$),einen Prädiktor (10) zur Bildung der Schätzwerte und eine erste Subtraktionsvorrichtung (2a) zur Bildung der Differenzsignale aufweist, **dadurch gekennzeichnet,** daß zur Verarbeitung der Differenzsignale ($\Delta$) diese über eine Einrichtung zur Ausgabe eines zu einem Differenzsignal zugehörigen Quantisierungsfehlers (11) an einen ersten Eingang eines zweiten Addierers (12) geführt werden, daß ein zweiter Eingang des zweiten Addierers (12) mit den Differenzsignalen ($\Delta$) beschaltet ist und am Ausgang des zweiten Addierers (13) Signale ($\Delta q$) zur Signalübertragung abgegriffen werden, daß ein Ausgang der Einrichtung zur Ausgabe eines zu einem Differenzsignal zugehörigen Quantisierungsfehlers (11) mit dem ersten Eingang des ersten Addierers (8) verschaltet ist und ein zweiter Eingang des ersten Addierers (8) mit digitalisierten Bildpunktsignalen (s) beaufschlagt ist und daß der Ausgang des ersten Addierers (8) über den Prädiktor (10) mit der ersten Subtraktionsvorrichtung (2a) verschaltet ist.

2. Anordnung nach Anspruch 1, **dadurch gekennzeichnet,** daß der Prädiktor in einen eindimensionalen (14) und einen zwei/dreidimensionalen Prädiktor (15) aufgespalten ist, daß der zwei/dreidimensionale Prädiktor (15) zwischen dem Ausgang des ersten Addierers (8) und der ersten Subtraktionsvorrichtung (2a) und der eindimensionale Prädiktor (14) zwischen dem Ausgang des ersten Addierers (8) und einer zweiten Subtraktionsvorrichtung (2b) geschaltet ist, und daß die zweite Subtraktionsvorrichtung (2b) zwischen der ersten Subtraktionsvorrichtung (2a) und der Einrichtung zur Ausgabe eines zu einem Differenzsignal zugehörigen Quantisierungsfehlers (11) angeordnet ist.

3. Anordnung nach Anspruch 2, **dadurch gekennzeichnet,** daß der eindimensionale Prädiktor (14) eine Serienschaltung aus einem Register (16) und einem Bewerter (17) enthält.

4. Anordnung nach Anspruch 1, **dadurch gekennzeichnet,** daß der Prädiktor in einen eindimensionalen und einen zwei/dreidimensionalen Prädiktor aufgespalten ist, daß der zwei/dreidimensionale Prädiktor (15) zwischen dem Ausgang des ersten Addierers (8) und der ersten Subtraktionsvorrichtung (2a) geschaltet ist, daß der eindimensionale Prädiktor in einen ersten und zweiten Prädiktoranteil (18, 19) aufgeteilt ist, daß der zweite Prädiktoranteil (19) zwischen dem ersten Eingang des ersten Addierers (8) und einer zweiten Subtraktionsvorrichtung (2b) und der erste Prädiktoranteil (18) zwischen dem ersten Eingang des ersten Addierers (8) und einer dritten Subtraktionsvorrichtung (2c) geschaltet ist, daß die dritte Subtraktionsvorrichtung (2c) vor und die zweite Subtraktionsvorrichtung (2b) nach der ersten Subtraktionsvorrichtung (2a) angeordnet ist.

5. Anordnung nach Anspruch 4, **dadurch gekennzeichnet,** daß der erste und zweite Prädiktoranteil (18, 19) jeweils eine Reihenschaltung eines Registers (16′, 16″) und eines Bewerters (17′, 17″) enthält.

6. Anordnung nach Anspruch 4, **dadurch gekennzeichnet,** daß ein erstes Register (20) zwischen der dritten und ersten Subtraktionsvorrichtung (2c, 2a) und ein zweites Register (21) nach der zweiten Subtraktionsvorrichtung (2b) angeordnet ist, daß eine aus einem dritten und vierten Register (22, 23) bestehende Serienschaltung mit einem ersten Anschluß mit dem zweiten Eingang des ersten Addierers (8) verschaltet ist und mit einem zweiten Anschluß mit den digitalisierten Bildpunktsignalen s beaufschlagt wird, daß der zweite Prädiktoranteil (19′) über das vierte Register (23) mit der dritten Subtraktionsvorrichtung (2c) verschaltet ist und daß eine in dem zwei/dreidimensionalen Prädiktor (15) enthaltener Bild- oder Zeilenspeicher um ein Register (24) verkürzt ist.

7. Anordnung nach Anspruch 6, **dadurch gekennzeichnet,** daß zwischen der ersten und zweiten Subtraktionsvorrichtung ein fünftes Register (25) und zwischen dem ersten Anschluß einer aus einem dritten und vierten Register (22, 23) bestehenden Serienschaltung und dem zweiten Eingang des ersten Addierers (18) ein sechstes Register (26) angeordnet ist und daß ein in dem zwei/dreidimensionalen Prädiktor (15′) enthaltener Bild- oder Zeilenspeicher um ein weiteres Register (27) verkürzt ist.

8. Anordnung nach Anspruch 6 oder 7, **dadurch gekennzeichnet,** daß die Anordnung ein erster und zweiter Multiplexer (28, 29), eine Überlauferkennung (30) und eine vierte Subtraktionsvorrichtung (31) enthält, daß die Überlauferkennung (30) zwischen dem Ausgang des ersten Addierers (8) und einem Steuereingang des ersten und zweiten Multiplexers (28, 29) geschaltet ist, daß der erste Eingang des ersten Multiplexers (28) mit einem unteren Grenzwert (G⁻), der zweite Eingang desselben mit einem oberen Grenzwert (G⁺) und ein dritter Eingang des ersten Multiplexers (28) mit dem Ausgang des ersten Addierers (8) verschaltet ist, daß ein Ausgang des ersten Multiplexers (28) mit dem zwei/ dreidimensionalen Prädiktor (15′) verbunden ist, und daß der zweite Multiplexer (29) mit einem ersten Eingang und einem ersten Ausgang zwischen der zweiten Subtraktionsvorrichtung (2b) und dem zweiten Register (21) geschaltet ist, daß der zweite und dritte Eingang des zweiten Multiplexers (29) mit der vierten Subtraktionsvorrichtung (31) verbunden ist, wobei ein erster Eingang der vierten Subtraktionsvorrichtung (31) mit dem Ausgang des zwei/ dreidimensionalen Prädiktors (15′) verbunden ist und ein zweiter Eingang der dritten Subtraktionsvorrichtung (31) mit einem Schaltungspunkt (32) zwischen dem dritten und vierten Register (22, 23) verschaltet ist.

9. Anordnung nach Anspruch 8, **dadurch gekennzeichnet,** daß die vierte Subtraktionsvorrichtung (31) einen ersten, zweiten und dritten Subtrahierer (33, 34, 35) enthält, wobei je ein erster und zweiter Eingang des ersten Subtrahierers (33) mit jeweils dem ersten und zweiten Eingang der vierten Subtraktionsvorrichtung (31) verbunden ist, ein Ausgang des ersten Subtrahierers (33) auf jeweils einen ersten Eingang des zweiten und dritten Subtrahierers (34, 35) geschaltet ist, daß der zweite Eingang des zweiten Substrahierers (34) mit einem unteren Grenzwert (G⁻) und der zweite Eingang des dritten Subtrahierers (35) mit einem oberen Grenzwert (G⁺) verschaltet ist, daß der Ausgang des zweiten und dritten Subtrahierers (34, 35) jeweils den ersten und zweiten Ausgang der vierten Subtraktionsvorrichtung (31) bilden.

10. Anordnung nach Anspruch 9, **dadurch gekennzeichnet,** daß zwischen dem oberen Grenzwert (G⁺) und dem zweiten Eingang des zweiten Subtrahierers (34) ein Bewerter (36) und zwischen dem unternen Grenzwert (G⁻) und dem zweiten Eingang des dritten Subtrahierers (35) ein weiterer Bewerter (37) angeschlossen ist.

11. Anordnung nach einem der Ansprüche 6 bis 10, **dadurch gekennzeichnet,** daß der erste und zweite Prädiktoranteil (18′, 19′) je einen Bewerter (17′, 17″) enthält.

**Claims**

1. Arrangement for DPCM coding at a high data rate, in which prediction values are subtracted in each case from digitised picture element signals at the input (1) and the difference signals obtained are utilised for signal transmission after a processing, having a recursive signal path which has a first adder (8) for forming reconstructed picture element signals ($s_R$), a predictor (10) for forming the estimated values and a first subtraction means (2a) for forming the difference signals, characterised in that, for processing the difference signals ($\Delta$), the latter are supplied via a means for outputting a quantisation error (11) pertaining to a difference signal to a first input of a second adder (12), in that a second input of the second adder (12) receives the difference signals ($\Delta$), and signals ($\Delta q$) for signal transmission are picked up at the output of the second adder (13), in that an output of the means for outputting a quantisation error (11) pertaining to a difference signal is connected to the first input of the first adder (8), and a second input of the first adder (8) receives digitised picture element signals (s), and in that the output of the first adder (8) is connected via the predictor (10) to the first subtraction means (2a).

2. Arrangement according to Claim 1, characterised in that the predictor is divided into a one-dimensional (14) and a two/three-dimensional predictor (15), in that the two/three-dimensional predictor (15) is connected between the output of the first adder (8) and the first subtraction means (2a), and the one-dimensional predictor (14) is connected between the output of the first adder (8) and a second subtraction means (2b), and in that the second subtraction means (2b) is arranged between the first subtraction means (2a) and the means for outputting a quantisation error (11) pertaining to a difference signal.

3. Arrangement according to Claim 2, characterised in that the one-dimensional predictor (14) contains a series circuit comprising a register (16) and an evaluator (17).

4. Arrangement according to Claim 1, characterised in that the predictor is divided into a one-dimensional and a two/three-dimensional predictor, in that the two/three-dimensional predictor (15) is connected between the output of the first adder (8) and the first subtraction means (2a), in that the one-dimensional predictor is divided into a first and second predictor part (18, 19), in that the second predictor part (19) is connected between the first input of the first adder (8) and a second subtraction means (2b), and the first predictor part (18) is arranged between the first input of the first adder (8) and a third subtraction means (2c), in that the third subtraction means (2c) is arranged before and the second subtraction means (2b) is arranged after the first subtraction means (2a).

5. Arrangement according to Claim 4, characterised in that the first and second predictor part (18, 19) contain in each case a series circuit comprising a register (16', 16'') and an evaluator (17', 17'').

6. Arrangement according to Claim 4, characterised in that a first register (20) is arranged between the third and first subtraction means (2c, 2a), and a second register (21) is arranged after the second subtraction means (2b), in that a series circuit comprising a third and fourth register (22, 23) is connected with a first terminal to the second input of the first adder (8) and receives with a second terminal the digitised picture element signals s, in that the second predictor part (19') is connected via the fourth register (23) to the third subtraction means (2c), and in that a frame memory or line memory contained in the two/three-dimensional predictor (15) is reduced by one register (24).

7. Arrangement according to Claim 6, characterised in that a fifth register (25) is arranged between the first and second subtraction means, and a sixth register (26) is arranged between the first terminal of a series circuit comprising a third and fourth register (22, 23) and the second input of the first adder (18), and in that a frame memory or line memory contained in the two/three-dimensional predictor (15') is reduced by a further register (27).

8. Arrangement according to Claim 6 or 7, characterised in that the arrangement contains a first and second multiplexer (28, 29), an overflow detection means (30) and a fourth subtraction means (31), in that the overflow detection means (30) is connected between the output of the first adder (8) and a control input of the first and second multiplexer (28, 29), in that the first input of the first multiplexer (28) is connected to a lower limit value ($G^-$), the second input thereof is connected to an upper limit value ($G^+$) and a third input of the first multiplexer (28) is connected to the output of the first adder (8), in that one output of the first multiplexer (28) is connected to the two/three-dimensional predictor (15'), and in that the second multiplexer (29) is connected with a first input and a first output between the second subtraction means (2b) and the second register (21), and in that the second and third input of the second multiplexer (29) is connected to the fourth subtraction means (31), a first input of the fourth subtraction means (31) being connected to the output of the two/three-dimensional predictor (15'), and a second input of the third subtraction means (31) being connected to a circuit point (32) between the third and fourth register (22, 23).

9. Arrangement according to Claim 8, characterised in that the fourth subtraction means (31) contains a first, second and third subtractor (33, 34, 35), a first and second input of the first subtractor (33) in each case being connected to the first and second input of the fourth subtraction means (31) in each case, one output of the first subtractor (33) being connected to a first input of the second and third subtractor (34, 35) in each case, in that the second input of the second subtractor (34) is connected to a lower limit value (G⁻) and the second input of the third subtractor (35) is connected to an upper limit value (G⁺), and in that the output of the second and third subtractor (34, 35) forms in each case the first and second output of the fourth subtraction means (31).

10. Arrangement according to Claim 9, characterised in that an evaluator (36) is connected between the upper limit value (G⁺) and the second input of the second subtractor (34), and a further evaluator (37) is connected between the lower limit value (G⁻) and the second input of the third subtractor (35).

11. Arrangement according to one of Claims 6 to 10, characterised in that the first and second predictor part (18', 19') each contains an evaluator (17', 17'').

**Revendications**

1. Dispositif pour réaliser le codage MICD avec une cadence élevée de données, dans lequel respectivement des valeurs de prédiction sont soustraites de signaux numérisés de points d'image à l'entrée (1) et les signaux de différence obtenus sont utilisés après un traitement pour la transmission de signaux, et comportant une voie récursive des signaux, qui possède un premier additionneur (8) servant à former des signaux reconstitués de points d'image (s$_R$), un dispositif de prédiction (10) pour former les valeurs estimées et un premier dispositif de soustraction (2a) servant à former les signaux de différence, caractérisé par le fait que pour le traitement des signaux de différence (Δ), ces derniers sont envoyés par l'intermédiaire d'un dispositif servant à délivrer une erreur de quantification (11) associée à un signal de différence, à une première entrée d'un second additionneur (12), qu'une seconde entrée du second additionneur (12) est chargée par les signaux de différence (Δ) et que des signaux (Δq) sont prélevés à la sortie du second additionneur (13) en vue de leur transmission, qu'une sortie du dispositif servant à délivrer une erreur de quantification (11) associée à un signal de différence est raccordée à la première entrée du premier additionneur (8) et qu'une seconde entrée du premier additionneur (8) est chargée par les signaux numérisés de points d'image (s) et que la sortie du premier additionneur (8) est raccordée, par l'intermédiaire du dispositif de prédiction (10) au premier dispositif de soustraction (2a).

2. Dispositif suivant la revendication 1, caractérisé par le fait que le dispositif de prédiction est subdivisé en un dispositif de prédiction unidimensionnel (14) et un dispositif de prédiction bidimensionnel/tridimensionnel (15), que le dispositif de prédiction bidimensionnel/tridimensionnel (15) est branché entre la sortie du premier additionneur (8) et le premier dispositif de soustraction (2a) et que le dispositif de prédiction unidimensionnel (14) est branché entre la sortie du premier additionneur (8) et un second dispositif de soustraction (2b), et que le second dispositif de soustraction (2b) est branché entre le premier dispositif de soustraction (2a) et le dispositif servant à délivrer une erreur de quantification (11) associée à un signal de différence.

3. Dispositif suivant la revendication 2, caractérisé par le fait que le dispositif de prédiction unidimensionnel (14) comporte un circuit série formé d'un registre (16) et d'un dispositif de pondération (17).

4. Dispositif suivant la revendication 1, caractérisé par le fait que le dispositif de prédiction est subdivisé en un dispositif de prédiction unidimensionnel et en un dispositif de prédiction bidimensionnel/tridimensionnel, que le dispositif de prédiction bidimensionnel/tridimensionnel (15) est branché entre la sortie du premier additionneur (8) et le premier dispositif de soustraction (2a), que le dispositif de prédiction unidimensionnel est subdivisé en des première et seconde parties (18,19), que la seconde partie (19) du dispositif de prédiction est branchée entre la première entrée du premier additionneur (8) et un second dispositif de soustraction (2b) et que la première partie (18) du dispositif de prédiction est branchée entre la première entrée du premier additionneur (8) et un troisième dispositif de soustraction (2c), que le troisième dispositif de soustraction (2c) est monté en amont du premier dispositif de soustraction (2a) et que le second dispositif de soustraction (2b) est disposé en aval du premier dispositif de soustraction (2a).

5. Dispositif suivant la revendication 4, caractérisé par le fait que les première et seconde parties (18,19) du dispositif de prédiction comportent chacune un circuit série formé d'un registre (16',16'') et d'un dispositif de pondération (17',17'').

6. Dispositif suivant la revendication 4, caractérisé par le fait qu'un premier registre (20) est disposé entre les troisième et premier dispositifs de soustraction (2c,2a) et qu'un second registre (21) est disposé en aval du second dispositif de soustraction (2b), qu'un circuit série formé par des troisième et quatrième registres (22,23) est raccordé par une première borne à la seconde entrée du premier additionneur (8) et reçoit, au niveau d'une seconde borne, des signaux numérisés de points d'image, que la seconde partie (19') du dispositif de prédiction est raccordée par l'intermédiaire du quatrième registre (23) au troisième dispositif de soustraction (2c) et qu'une mémoire d'images ou de lignes, qui est prévue dans le dispositif de prédiction bidimensionnel/tridimensionnel (15), est réduite d'un registre (24).

7. Dispositif suivant la revendication 6, caractérisé par le fait qu'un cinquième registre (25) est branché entre les premier et second dispositifs de soustraction, qu'un sixième registre (26) est disposé entre la première borne d'un circuit série formé par les troisième et quatrième registres (22,23), et la seconde entrée du premier additionneur (18) et une mémoire d'images ou de lignes, contenue dans le dispositif de prédiction bidimensionnel/tridimensionnel (15'), est réduite d'un second registre (27).

8. Dispositif suivant la revendication 6 ou 7, caractérisé par le fait qu'il comporte des premier et second multiplexeurs (28,29), une unité (30) d'identification de dépassement de capacité et un quatrième dispositif de soustraction (31), que l'unité d'identification de dépassement de capacité (30) est branchée entre la sortie du premier additionneur (8) et une entrée de commande des premier et second multiplexeurs (28,29), que la première entrée du premier multiplexeur (28) est raccordée à une valeur limite inférieure ($G^-$), que la seconde entrée de ce multiplexeur est raccordée à une valeur limite supérieure ($G^+$) et qu'une troisième entrée du premier multiplexeur (28) est raccordée à la sortie du premier additionneur (8), qu'une sortie du premier multiplexeur (28) est reliée au dispositif de prédiction bidimensionnel/tridimensionnel (15'), que le second multiplexeur (29) est raccordé, par une première entrée et par une première sortie, entre le second dispositif de soustraction (2b) et le second registre (21), que les seconde et troisième entrées du second multiplexeur (29) sont raccordées au quatrième dispositif de soustraction (31), la première entrée du quatrième dispositif de soustraction (31) étant raccordée à la sortie du dispositif de protection bidimensionnel/tridimensionnel (15'), tandis qu'une seconde entrée du troisième dispositif de soustraction (31) est raccordé à un point (32) du circuit situé entre les troisième et quatrième registres (22,23).

9. Dispositif suivant la revendication 8, caractérisé par le fait que le quatrième dispositif de soustraction (31) comporte des premier, second et troisième soustracteurs (33,34,35), respectivement des première et seconde entrées du premier soustracteur (33) étant raccordées respectivement aux première et seconde entrées du quatrième dispositif de soustraction (31), tandis qu'une sortie du premier soustracteur (33) est raccordée respectivement à une première entrée des second et troisième soustracteurs (34,35), que la seconde entrée du second soustracteur (34) est raccordée à une valeur limite inférieure ($G^-$) et que la seconde entrée du troisième soustracteur (35) est raccordée à une valeur limite supérieure ($G^+$), et que la sortie des second et troisième soustracteurs (34,35) forme respectivement les première et seconde sorties du quatrième dispositif de soustraction (31).

10. Dispositif suivant la revendication 9, caractérisé par le fait qu'un dispositif de pondération (36) est monté entre la valeur limite supérieure ($G^+$) et la seconde entrée du second soustracteur (34) et qu'un autre dispositif de pondération (37) est situé entre la valeur limite inférieure ($G^-$) et la seconde entrée du troisième soustracteur (35).

11. Dispositif suivant l'une des revendications 6 à 10, caractérisé par le fait que les première et seconde parties (18',19') du dispositif de prédiction comportent chacune un dispositif de pondération (17',17").

## FIG 1

## FIG 2

FIG 3

FIG 4

FIG 5

FIG 6

FIG 7

# FIG 8